(19) Europäisches Patentamt
European Patent Office
Office européen des brevets

(11) **EP 2 096 755 A1**

(12) **EUROPEAN PATENT APPLICATION**
published in accordance with Art. 153(4) EPC

(43) Date of publication:
**02.09.2009 Bulletin 2009/36**

(51) Int Cl.:
**H03H 11/44** *(2006.01)*  **H03H 11/10** *(2006.01)*
**H03B 5/08** *(2006.01)*

(21) Application number: **07848129.8**

(22) Date of filing: **14.11.2007**

(86) International application number:
**PCT/ES2007/070187**

(87) International publication number:
**WO 2008/059097 (22.05.2008 Gazette 2008/21)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **15.11.2006 ES 200603017**

(71) Applicant: **Universitat De València, Estudi General 46010 València (ES)**

(72) Inventor: **RAMÍREZ MUÑOZ, Diego 46010 València (ES)**

(74) Representative: **Barlocci, Anna ZBM Patents Zea, Barlocci & Markvardsen C/ Balmes, 114 - 4o 08008 Barcelona (ES)**

(54) **ELECTRONIC CIRCUIT FOR OBTAINING A VARIABLE CAPACITATIVE IMPEDANCE**

(57) The invention is **characterized in that** it comprises a plurality of impedances (R2, C3, R4, R5) and at least one operational amplifier (51, 52), and means (53) for connecting a resistive sensor (Rs) to the electronic circuit (50) such that, once the resistive sensor has been connected to the electronic circuit, a resulting electronic circuit is obtained that consist of the electronic circuit and the resistive sensor connected thereto, the input impedance (Zinp) of which corresponds to that of a variable capacitance as a function of the resistive sensor (Rs). A capacitive input impedance that can vary as a function of a sensor is obtained.

FIG.5

EP 2 096 755 A1

**Description**

The present invention refers to an electronic circuit for obtaining a variable capacitive impedance, by using a resistive sensor. More precisely, it refers to an electronic circuit based on the Generalized Impedance Converter (GIC) circuit, which can be configured in such a way that its entry impedance corresponds to a capacity, being said capacity variable based on the value of the electric resistance of a resistive sensor, and being said resistive sensor one of the impedances of the converter circuit, in such a way that the synthesized capacity with the converter circuit (GIC) varies based on the value of the electric resistance of said resistive sensor.

The invention is suitable to be used in the field of measurements and instrumentation, mainly in the cases where a variable capacity dependent to the measured parameter by a resistive sensor is needed. Said cases may be, for example, industrial control systems, medical or automobile industry instrumentation, and more precisely low consumption and low tension powered systems, which may be powered by battery.

**Background Art**

A Generalized Impedance Converter (GIC) circuit is an electronic circuit which comes from one of the gyrator circuits proposed by Antoniou in 1969, as described, for example, in [A. Antoniou, "Realization of gyrators using operational amplifiers and their use in RC-active network synthesis". Proc. IEE, vol. 116, pp. 1838-1850].

The objective of a gyrator circuit is to reverse, at the entry port of a two port network, the type of impedance connected to the exit port, whereas a GIC circuit allows to configure the impedance in a port (they are mono-port networks), from five impedances.

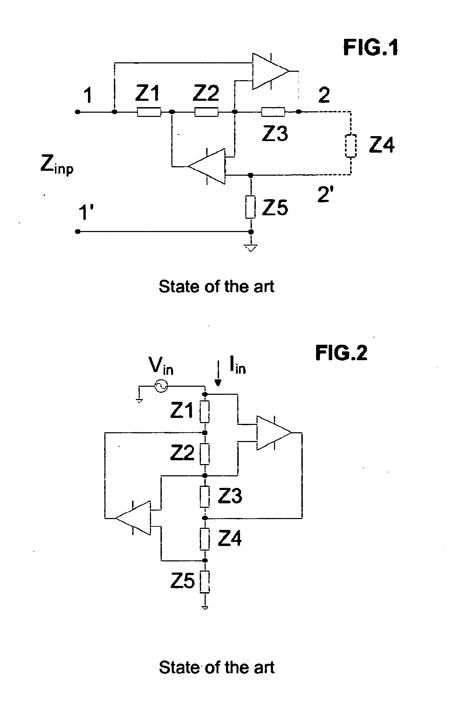

Fig.1 shows one of said gyrator circuits of Antoniou, where, if an impedance Z4 is connected between the exit port 2-2', considering that the operational amplifiers are ideal, the entry impedance $Z_{inp}$ of the converter circuit, seen from the entry port 1-1' is:

$$Z_{inp} = \frac{Z_1.Z_3.Z_5}{Z_2.Z_4}$$

In Fig.2 the resulting converter circuit (GIC) is shown which in its original form (an impedance Z4 is added to the Antoniou gyrator). Said structure has been widely used for synthesizing inductances using only resistors, condensers and operational amplifiers, mainly in the design of active filters with usage in audio, as described, for example, in [T. Deliyannis, Y. Sun, J.K. Fidler, Continuous-time active filter design, CRC Press, Boca Raton, FL, 1999, Chap. 3], in [S. Franco, Design with operational amplifiers and analog integrated circuits, McGraw-Hill, 3rd ed., New York, 2001, Chap. 4], or in [R. Schaumann, M. E. van Valkenburg, Design of analog filters, Oxford University Press, New York, 2001, Chap. 14]. Basically, the performance of the entry impedance $Z_{inp}$ depends on which type of impedance (resistive or capacitive) is assigned to each impedances Z1 to Z5, applying an alternate voltage $V_{in}$ which generates a current $I_{in}$.

The previously described is the "classic" approach of a GIC circuit. More recently, an application of a GIC circuit has been proposed, within the field of instrumentation, in which the circuit is used, with its classic approach, as a capacitive impedance, as described, for example, in [D. M. G. Preethichandra, K. Shida, "A simple interface circuit to measure very small capacitance changes in capacitive sensors" Proc. of the 17th IEEE Instrumentation and Measurement Technology Conference, Baltimore 2000, vol. 1, pp. 406-409]. It is important to note that both its classic approach in the filter design and in the field of instrumentation, the existing voltages and currents in the GIC circuit are variable in time.

More recently, a new performance of the GIC circuit has been proposed, which consists of polarizing it, not with variable signals in time (AC), but, on the contrary, with continuous signals (DC). The main objective of this change is the use of the GIC in the field of instrumentation and measurements, but not as a capacitive impedance, but as a polarizing circuit for sensors, being one of the impedances of the GIC circuit, a resistive sensor.

From this new application point of view, it is possible to distinguish two different configurations: a first configuration where the GIC circuit is powered by a reference voltage $V_{ref}$, and a second configuration where the GIC circuit is powered by a reference current $I_{ref}$.

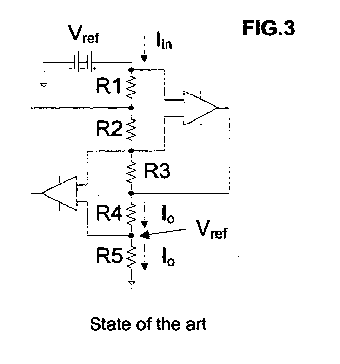

As shown in Fig.3, referring to the first configuration, a continuous voltage $V_{ref}$ is connected to the entry of the GIC, and the five impedances are five resistors R1 to R5, being one of them (R4) a resistive sensor. From said new configuration it is achieved that the current going through the resistor R4 to be constant, since, when the voltage values $V_{ref}$ and resistor R5 are fixed, the current (supposing that the operational amplifiers) which circulates through R4 is the same that the one passing through R5 and is obtained using the following formula:

$$I_{R4} = I_o = \frac{V_{ref}}{R5}$$

This way, a simple way of polarizing sensors with constant current is obtained, since it is enough that resistor R4 is the sensor to be polarized. Said technique has derived in different publications, such as *[D. Ramirez-Muñoz, S. Casans-Berga, C. Reig, "Current loop generated from a generalized impedance converter: a new sensor signal conditioning circuit". Review of Scientific Instruments, 76, 1, (2005), 066103]*, *[D. Ramírez-Muñoz, S. Casans-Berga, C. Reig, P. J. P. Freitas, "Generalized impedance converter as a new sensor signal conditioning circuit", Proc of the 22nd IEEE Instrumentation and Measurement Technology Conference, May 17-19, 2005, Ottawa, 587-591]*, *[D. Ramirez, S. Casans, C. Reig, A. E. Navarro, J. Sánchez., "Build a precise DC floating-current source". EDN, August 2005, pp. 83-84]*, or *[M. Villalobos Pedrero, D. Ramirez Muñoz, S. Casans Berga, J. Sánchez Moreno, C. Reig Escrivá, A. E. Navarro Antón. "Red de sensores inteligentes configurable basada en micropocesador con enlace RF accesible via Internet". Mundo Electrónico, n°371]*.

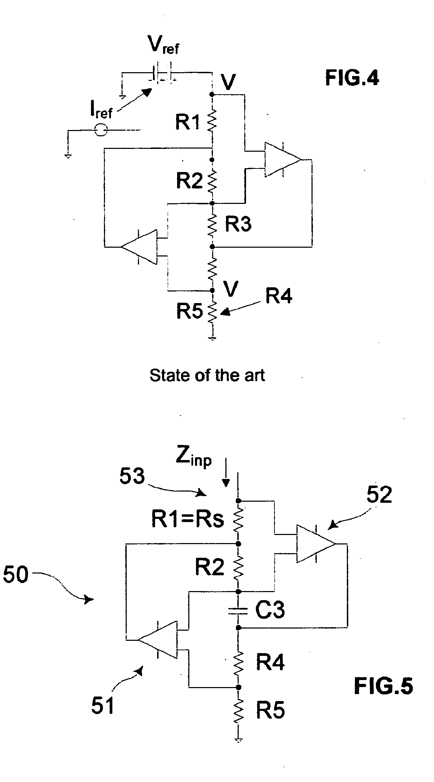

Referring to the second configuration, the circuit shown in Fig.4 was considered when thinking about the possibility of polarizing with a constant current a non-floating resistive sensor (like the sensor found in R4, in the previous configuration). Basically, in said second configuration, reference voltage $V_{ref}$ in the entry is substituted by a reference current $I_{ref,}$ changing the location of the resistive sensor of resistor R4 to resistor R5, in such a way that the resistive sensor used is directly one of the terminals connected to earth. This way, the current passing through the sensor on the resistor R5 is:

$$I_{R5} = \frac{V}{R_5} = \frac{R_1 \cdot R_3}{R_2 \cdot R_4} \cdot I_{ref} = n \cdot I_{ref}$$

Said expression establishes that, when giving values to resistors R1, R2, R3, and R4, it is possible to control the current passing through resistor R5, independently of its value. Therefore, with the described configuration, it is possible to obtain both a circuit for polarizing a sensor connected to earth with constant current, and a current-current converter. Said new converter derived from the GIC circuit has been described in different publications such as *[A. Blat González, D. Ramirez Muñoz, J. Sánchez Moreno, S. Casans Berga, A. E. Navarro Antón, F. Maturell Nápoles. "Sistema de medida de temperatura y presión con sensores alimentados a corriente constante mediante convertidor generalizado de impedancias". Mundo Electrónico, n°372]*, *[D. Ramirez Muñoz, J. Sánchez, S. Casans, C. Reig, A. E. Navarro, "Series Sensor Current Loop from a Generalized Impedance Converter Circuit with Reference Current Input", Proc of the 23rd IEEE Instrumentation and Measurement Technology Conference, pp. 2265-2270, Sorrento (Italy, 24-27 April 2006)]*, *[D. Ramirez Muñoz, J. Sánchez, S. Casans, C. Reig, A. E. Navarro "Current-to-current converter from a DC polarized generalized impedance converter circuit with input reference current". Review of Scientific Instruments, 77, 056101 (May, 2006)]*, o *[D. Ramirez Muñoz, J. Sánchez Moreno, S. Casans Berga, E. Castro Montero, C. Reig, A. E. Navarro Antón, "Temperature compensation of Wheatstone bridge magnetoresistive sensors based on generalized impedance converter with input reference current". Review of Scientific Instruments. 77, 105102 (October 2006), vol 17, no. 10]*.

On the other hand, the PCT application WO 9602975 A1, entitled "Filtro loop con tiempo de respuesta variable", with applicant *Matsushita Communication Industrial Corporation of America*, describes another way of using the GIC circuit for configuring a capacitance. More precisely, the invention refers to a way for configuring an RC low-pass filter with a GIC circuit (configured as a condenser), for obtaining a filter with a programmable or voltage-controlled cut-frequency. For doing so, the GIC circuit comprises a FET transistor with a variable resistor voltage-controlled, in such a way that a proportional relation is achieved between the cut frequency and the value of the resistor of the FET transistor.

## Summary of the Invention

Therefore, it is an objective of the present invention to provide an electronic circuit for obtaining a variable capacitive entry impedance depending on a sensor.

This is achieved through claim 1 providing an electronic circuit for obtaining a variable capacitive impedance, with a resistive sensor, which comprises a plurality of impedances and at least an operational amplifier, and means for connecting the resistive sensor to the electronic circuit, which obtains a resulting electronic circuit, which comprises the electronic circuit and the resistive sensor connected to it, whose entry impedance corresponds to the impedance of a variable condenser which depends on the resistive sensor.

This way, a circuit is obtained which varies its entry capacity depending on the parameter measured by the resistive sensor (the circuit is "seen" through one of its entry ports as a capacitor), and therefore the value of the resistive sensor is not controlled by a voltage of the circuit but by the parameter which is to be measured. Said parameter may be a physical, chemical one, etc., but it is desired that it provokes changing in the resistance.

Also, the electronic circuit may be configured depending on the value and type of impedances. When the resistive sensor is connected to the electronic circuit, an electronic circuit is obtained, which may be a GIC circuit, which, with a suitable configuration, allows obtaining in its entry a variable capacity depending on the resistive sensor. It doesn't seem that a configuration with three condensers for a GIC circuit is recommended, since problems are generated with the polarization currents of the operational amplifiers, provoking an incorrect performance of the GIC.

In any case, at least one impedance of the plurality of impedances has to be a capacitive one, since it is necessary to have at least one capacity in the circuit to give a total entry capacitive character to the circuit. Also, at least one impedance from the plurality of impedances has to be a resistor, in such a way that if only one of the impedances is capacitive, and the rest of impedances have to be resistive.

According to a preferred embodiment of the invention, the variable entry capacity of the resulting circuit is inversely proportional to the resistive sensor.

According to a preferred embodiment of the invention, the electronic circuit comprises two operational amplifiers and four impedances. This way, when the resistive sensor is connected to the electronic circuit, a GIC is obtained, as previously described.

From the described electronic circuit, it is possible to obtain a device for obtaining an electrical signal with a variable oscillation frequency, from a resistive sensor, which comprises an oscillator circuit and the electronic circuit for obtaining a variable capacitive impedance, from a resistive sensor, previously described, being connected said oscillator circuit and said electronic circuit in such a way that, once connected the resistive sensor to the electronic circuit, the oscillation capacity of the oscillator circuit depends on the resulting variable capacitive entry impedance, obtaining in the exit of the oscillator circuit an electrical signal whose oscillation frequency is variable depending on the resistive sensor.

This way, the obtained result is because of the analog processing of the information by means of an oscillator which comprises a GIC, which comprises a resistive sensor itself.

According to a preferred embodiment of the device, the oscillation frequency of the electrical signal is directly proportional to the resistive sensor. This feature is particularly suitable in "direct interfaces with the digital intelligence". All of the systems which perform a half digital processing of measurements may be based in a microprocessor, a digital processor of the signal, a programmable automaton, or a personal computer. The most simple way of incorporating the information which is being measured to all of them, in this case, from the resistive sensors, is the conversion of the information to a variable frequency signal. This is because the described digital processors have a port referred as timer, which is directly connectible to the variable frequency signal and measuring (count) its value.

Therefore, with said device it is achieved a direct conversion of the electrical resistance value of the resistive sensor to frequency, by means of the use of a GIC as the oscillation capacitance of an oscillator circuit. This way, from the described device, it is possible to obtain a signal whose frequency is directly proportional to the value of electrical resistance of the resistive sensor.

According to another embodiment of the invention, the resulting electronic circuit is connected to earth through one of its entry ports. This way, the use of the electronic circuit as an oscillation capacitance of an oscillator circuit is suitable for the oscillator circuits where the oscillation capacitance is connected to earth (for example, LM331 or LM566C type oscillators). In oscillators (for example, XR-2206) where the capacitance associated to the oscillation is floating, the electronic circuit (more precisely, when it is a GIC circuit, that is, when the resistive sensor is connected to the electronic circuit) it has an erratic performance.

On the other hand, the oscillator circuit may be a square signal generating circuit, and the oscillator circuit may comprise an integrated circuit of the 555 type, which is one of the most used timer circuits in the field of electronics. One of its most widely uses is as a square signal generating circuit.

## Brief description of the drawings

For a major clarity of the above described, drawings are attached wherein, in a schematic form, and only as a non-limitative example, a preferred embodiment is depicted.

In the drawings:

Fig.1 shows a diagram in the form of an electronic circuit of a gyrator circuit proposed by Antoniou, according to the state of the art;

Fig.2 shows a diagram in the form of an electronic circuit of the general structure of a GIC, according to the state of the art;

Fig.3 shows a diagram in the form of an electronic circuit of a GIC electronic circuit powered by a reference voltage $V_{ref}$, according to the state of the art;

Fig.4 shows a diagram in the form of an electronic circuit of a GIC electronic circuit powered by a reference current $I_{ref,}$ according to the state of the art;

Fig.5 shows a diagram in the form of an electronic circuit of a GIC electronic circuit configured as a variable capacitance which depends on a resistive sensor, according to the present invention;

Fig.6a shows a diagram in the form of an electronic circuit of a 555 timer circuit, configured as a square signal generator;

Fig.6b shows a diagram of the wave-forms associated with the timer circuit of Fig.6a; and

Fig.7 shows a diagram in the form of an electronic circuit of a direct converting device of resistive sensor to frequency, which comprises the timer circuit of Fig.6a and the GIC of Fig.5.

**Description of the preferred embodiments**

In the following a description of a preferred embodiment of the invention will be done, where the electronic circuit for obtaining a variable capacity entry impedance, depending on a resistive sensor, comprises four impedances, one of them being a condenser and the rest being resistors, and two operational amplifiers, said elements being connected in such a way that, when a resistive sensor is connected to the electronic circuit, a Generalized Impedance Converter is obtained, with a variable capacitive entry impedance depending on the resistive sensor. From the obtained GIC circuit, it is possible, as it will be described, to perform a direct conversion from resistive sensor to frequency, that is, it is possible to obtain a signal whose frequency is directly proportional to the value of the electrical resistance of the resistive sensor.
Therefore, giving adequate values to the previously described five impedances (including the resistive sensor when it is connected to the electronic circuit), it is possible to configure the GIC circuit in such a way that its entry impedance corresponds to the impedance of a condenser. Also, if one of said five impedances is a variable resistive sensor, as previously described, the synthesized capacity with the GIC is also variable. In summary, depending on the configuration of the five impedances which comprise the converting circuit (when the resistive sensor is connected to the electronic circuit), the GIC circuit may be seen as a variable capacitive sensor which depends on the parameter measured by the resistive sensor.
The parameter measured by the resistive sensor may be physic, chemical, etc., in such a way that the resistive sensor may be presented as, for example, a temperature sensor, luminosity sensor or gas concentration sensor.
As seen in Fig.5, for configuring the GIC circuit as a variable capacity, the electronic circuit 50 according to the invention, comprises a first resistor R2, a second resistor R4, a third resistor R5, a condenser C3 (therefore, the impedances Z1, Z2, Z4 and Z5 are resistive, and impedance Z3 is capacitive), a first operational amplifier 51, a second operational amplifier 52 and a connector 53 for connecting a resistive sensor Rs to the electronic circuit. It is important to note that the resistive sensor Rs, when connected to the electronic circuit 50, corresponds to the fourth resistor R1 of a GIC circuit in its original structure.
In a description of the design of the circuit, the entry of the GIC circuit is found connected to the non-inverter entry of the second operational amplifier 52 and the upper terminal of the fourth resistor R1 (more precisely, the resistive sensor Rs). The other terminal of said fourth resistor R1 is connected to the exit terminal of the first operational amplifier 51 and the upper terminal of the first resistor R2. The lower terminal of the first resistor R2 is connected to the inverter entries of the first operational amplifier 51 and the second operational amplifier 52, and to the upper terminal of the condenser C3. The lower terminal of said condenser C3 is connected to the upper terminal of the second resistor R4 and to the exit terminal of the second operational amplifier 52. On the other hand, the lower terminal of the second resistor R4 is connected to the upper terminal of the third resistor R5 and to the non-inverter entry of the first operational amplifier 51. Finally, the lower terminal of the third resistor R5 is connected to the reference terminal of the circuit.
According to another embodiment of the invention, the resistive sensor Rs may correspond to the third impedance Z5 of a GIC circuit in its original structure, also obtaining with said configuration a direct relation resistive sensor-frequency, as it will be described in the following, although not with all the resistive sensors.

It has been proved experimentally that the location of the resistive sensor Rs both in the fourth impedance Z1 and the third impedance Z5 of the GIC circuit results in a correct performance of the circuit. More precisely, it has been experimented that locating, in the fourth impedance Z1, a platinum thermo-resistor Pt100, a gas sensor and a resistor which depends on the luminous radiation (LDR), and in the third impedance Z5, a thermo-resistor Pt1000 has been placed, being in both cases the second impedance Z3 a capacity. Basically, disposing all the sensors in the third impedance Z5 was a problem when the values of the sensor are too low (like in the case of the thermo-resistor Pt100), since it exists the risk of saturating the second operational amplifier 52 of the GIC circuit. Nevertheless, with higher resistive values (for example the ones of the thermo-resistor Pt1000) no problems where found when placing the resistive sensor in the third impedance Z5.

Therefore, whatever the configuration of the impedances of the GIC circuit, it is essential that, for the correct performance of the GIC circuit, the no-saturation is assured in the second operational amplifier 52. Also, it doesn't seem adequate the GIC circuit to have three capacities among its impedances, since the polarization currents of the operational amplifiers may provoke an erratic performance of the GIC itself.

If an analysis of the converter circuit in Fig.5 is performed, an entry impedance is obtained of said circuit, seen from one of the entry ports, which may be represented by the following:

$$Z_{inp} = \frac{Rs \cdot \dfrac{1}{j \cdot w \cdot C3} \cdot R5}{R2 \cdot R4} = \frac{1}{j \cdot w \cdot C_{inp}}$$

Wherein

$$C_{inp} \equiv \frac{R2 \cdot R4 \cdot C3}{Rs \cdot R5}$$

As derived from the previous equation, the entry impedance of the electronic circuit 50 is a variable capacity, which inversely depends of the resistive sensor Rs, that is, the capacity is inversely proportional to the value of the electrical resistance of the resistive sensor Rs. This way, a variable capacity is obtained from a GIC circuit, the GIC being considered like a variable capacitive sensor which depends on the parameter which measures the resistive sensor.

On the other hand, the resistive sensor Rs has a functional dependence with the physical or chemical parameter to be measured (for example, temperature, pressure, luminosity, or gas concentration), which may be linear or not, depending on the type of sensor. Therefore, in general:

$$Rs = R_0 . f(x)$$

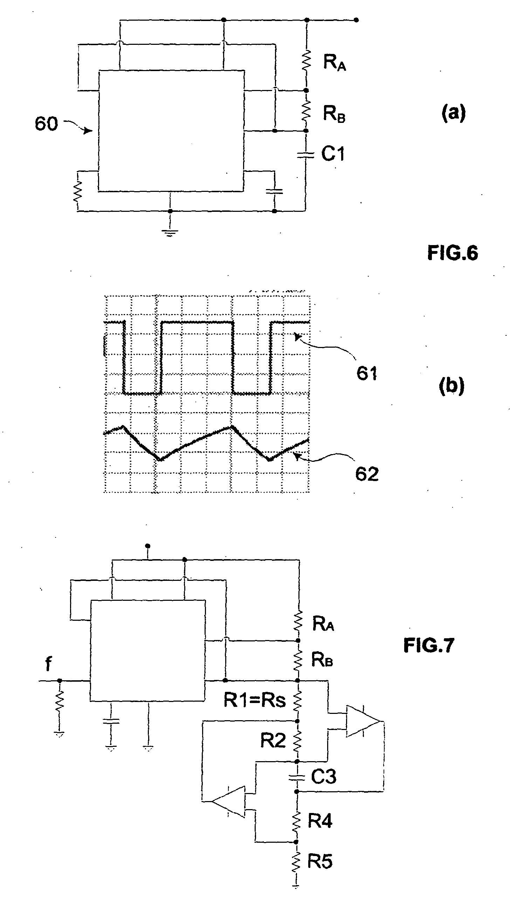

In the following a description of a device for obtaining an electrical signal with a variable oscillation frequency will be done, the frequency variable depending on a resistive sensor, which comprises an electronic circuit according to the invention. Said device is shown in Fig.7.

Basically, the device comprises an oscillator circuit (like a 555 circuit) and the electronic circuit 50 according to the present invention, being connected said oscillator circuit 60 and said electronic circuit 50 (the GIC circuit is connected directly to the terminals 2 and 6 of the 555 oscillator circuit), in such a way that, once connected the resistive sensor Rs to the electronic circuit 50, the oscillation capacity of the oscillator circuit 60 depends on the variable entry capacitive impedance of the GIC, obtaining at the exit of the circuit an electrical signal whose oscillation frequency depending on the electrical resistance value of the resistive sensor Rs. More precisely, the device allows performing a direct conversion from resistive sensor to frequency, in such a way that an electrical signal is obtained whose oscillation frequency is directly proportional to the value of electrical resistance of the resistive sensor.

A possible oscillator circuit is the integrated circuit 555 60 (one of the most popular oscillator circuit in the field of electronics), being one of its most common usages the one referred to a square signal generator. In Fig.6(a) an electronic configuration is shown, of the integrated circuit 555 in the previously described usage, where two timer resistors Ra and Rb and an oscillation capacity C1 are enough for generating a square signal 61, whose oscillation frequency comes from the following:

$$f = \frac{1,44}{(R_A + 2.R_B).C1}$$

If an analysis of the previous formula is performed, it is deduced that frequency "f" of the square signal 61 which provides the oscillator circuit 60 (see Fig.6.(b), where waveforms 61 and 62 are represented, associated with the oscillator circuit when functioning as a square signal generator) is inversely proportional to the oscillation capacity C1 and the timer resistors Ra and Rb.

If the oscillation capacity C1 needed by the oscillator circuit 60 for generating a square signal 61, is substituted by the GIC circuit of Fig.5, the oscillation capacity C1 of the oscillator circuit is dependent on the variable capacitive entry impedance $Z_{inp}$ of said converter circuit. With that, if the equation corresponding to the entry capacity of the converter circuit is substituted, in the equation corresponding to the oscillation frequency of the electric square signal:

$$C_{inp} \equiv \frac{R2.R4.C3}{Rs.R5}$$

$$f = \frac{1,44}{(R_A + 2.R_B).C1}$$

an oscillation frequency is obtained which corresponds to:

$$f = \frac{1,44}{(R_A + 2.R_B)} . \frac{Rs.R5}{R2.R4.C3}$$

Therefore, analyzing the previous equation, a direct conversion is achieved between resistive sensor and frequency, obtaining, as a result, a square signal whose frequency is directly proportional to the used resistive sensor Rs. The dependency (linear or not) which preserves the resistive sensor with the measured variable, is inherited by the oscillation frequency:

$$f = K.R_o.f(x)$$

being K:

$$K \equiv \frac{1,44}{(R_A + 2.R_B)} . \frac{R5}{R2.R4.C3}$$

In Fig.7 the final configuration of the device is shown, obtained from the oscillator circuit 60 and the GIC circuit which acts as an oscillation capacity of said oscillator circuit. Basically, it is a direct converter from resistive sensor to frequency. In said configuration (also shown in figures 2 and 5) it is important to note that the GIC circuit is connected to earth through one of its ports, and therefore only oscillator circuits whose oscillation capacity is connected to earth may be used (for example, oscillator circuits of the LM331 or LM566C type). In the case where the oscillators have a floating capacity (for example, XR-2206 type oscillators), the GIC circuit may not function correctly.

As a possible use of the above described, if the frequency of the electrical signal generated by the device is introduced in a processing circuit, it is possible to perform a direct conversion from resistive sensor Rs to digital codification of the frequency and, therefore, the magnitude which is to be measured.

As previously mentioned, the resistive sensor may be, for example, a temperature, luminosity or gas concentration sensor. With this type of sensors, very satisfying results have been obtained with frequency and resistance of the sensor. This way, tests have been performed with resistance temperature detectors (Pt100) and a decade box of resistors; the performance of resistors sensitive to luminous radiation (LDR) and resistive gas sensors has been simulated. With resistive humidity sensors, the obtained results haven't been as positive because of its variation range being wide (from 10-20 ohms with 90% of humidity, until 10-20 Mohms with 10% of relative humidity), which makes the GIC circuit to function incorrectly.

Although concrete preferred embodiments of the present invention have been described and represented, it is obvious that a skilled person in the art may introduce variants and modifications, or substitute the details for other equivalent ones, without getting outside the scope of protection defined by the accompanying claims.

In another configuration, it may be possible to use another gyrator circuit different from the GIC circuit for obtaining the lineal conversion resistance-frequency.

On the other hand, in this preferred embodiment, a 555 integrated circuit has been described as a square signal generator, but it is possible to use any generating circuit of any wave-form.

**Claims**

1. Electronic circuit (50) for obtaining a variable capacitive impedance ($Z_{inp}$), from a resistive sensor (Rs), **characterized in that that** it comprises a plurality of impedances (Z2, Z3, Z4, Z5) and at least one operational amplifier (51, 52), and means (53) for connecting a resistive sensor (Rs) to the electronic circuit (50), in such a way that, once connected the sensor to the electronic circuit, a resultant electronic circuit is obtained, comprising the electronic circuit and the resistive sensor connected to it, whose entry impedance ($Z_{inp}$) corresponds to one of a variable capacity depending on the resistive sensor (Rs).

2. Electronic circuit according to claim 1, wherein the resultant electronic circuit is a generalized impedance converter circuit.

3. Electronic circuit according to any of claims 1 or 2, wherein the variable capacitive entry impedance ($Z_{inp}$) of the resultant circuit is inversely proportional to the resistive sensor (Rs).

4. Electronic circuit according to any of claims 1 to 3, wherein at least one impedance (Z3) of the plurality of impedances is a capacitive one.

5. Electronic circuit according to any of claims 1 to 4, wherein at least one impedance (Z2, Z4, Z5) of the plurality of impedances is a resistive one.

6. Electronic circuit according to any of claims 1 to 5, wherein the resultant electronic circuit is connected to earth by one of its entry ports.

7. Electronic circuit according to any of claims 1 to 6, which further comprises two operational amplifiers (51, 52) and four impedances (Z2, Z3, Z4, Z5).

8. Device for obtaining an electrical signal of variable oscillation frequency from a resistive sensor (Rs), **characterized in that** it further comprises an oscillator circuit (60) and an electronic circuit (50) for obtaining a variable capacitive impedance, from a resistive sensor, according to any of claims 1 to 7, being connected said oscillator circuit (60) and said electronic circuit (50) in such a way that, once connected the resistive sensor to the electronic circuit, the oscillation capacity (C1) of the oscillator circuit (60) depends on the variable capacitive entry impedance ($Z_{inp}$) of the resultant electronic circuit, obtaining in the exit of the oscillator circuit (60) an electric signal whose oscillation frequency is variable depending on the resistive sensor (Rs).

9. Device according to claim 8, wherein the oscillation frequency of the electrical signal is directly proportional to the resistive sensor (Rs).

**10.** Device according to any of claims 8 or 9, wherein the oscillator circuit (60) is a square signal generator circuit.

**11.** Device according to any of claims 8 to 10, wherein the oscillator circuit comprises a 555 type integrated circuit (60).

**FIG.1**

1    Z1    Z2         2

$Z_{inp}$

Z3

Z4

1'              Z5    2'

State of the art

**FIG.2**

$V_{in}$    $I_{in}$

Z1

Z2

Z3

Z4

Z5

State of the art

**FIG.3**

State of the art

FIG.4

State of the art

FIG.5

60

$R_A$

$R_B$

C1

(a)

**FIG.6**

61

62

(b)

f

$R_A$

$R_B$

R1=Rs

R2

C3

R4

R5

**FIG.7**

## INTERNATIONAL SEARCH REPORT

| International application No. |
|---|
| PCT/ ES 2007/070187 |

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)

H03B, H03H

Documentation searched other than minimum documentation to the extent that such documents are included in the fields searched

Electronic data base consulted during the international search (name of data base and, where practicable, search terms used)

CIBEPAT,EPODOC

**C. DOCUMENTS CONSIDERED TO BE  RELEVANT**

| Category* | Citation of document, with indication, where appropriate, of the relevant passages | Relevant to  claim No. |
|---|---|---|
| X | US 5548279 A1 (GAINES) 20.08.1996 | 1-7 |
| Y | column 4, line 17- column 5, line 3 | 8-11 |
|  | column 5, line 40- column 5, line 64 |  |
| X | US 4185250 A1 (REGAN) 22.01.1980 | 1-7 |
|  | column 1ínea 39- column 2, line 44 |  |
|  | column 3, line 25- line 60 |  |
| X | US 4485356 A1 (FASSINO) 27.11.1984 | 1-7 |
|  | column 2, line 5- column 3, line 29 |  |
| X | FR 2582170 A1 (C. I. T. ALCATEL) 21.11.1986 | 1-7 |
|  | figure 2. |  |
| X | US 5499392 A (GRUNWELL) 12.03.1996 | 1-7 |
|  | column 8, line 21- column 9, line 10 |  |

☒ Further documents are listed in the continuation of Box C.          ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 25 February 2008          (19.02.2008) | (03/03/2008) |
| Name and mailing address of the ISA/ O.E.P.M. Paseo de la Castellana, 75 28071 Madrid, España. Facsimile No.   34 91 3495304 | Authorized officer L. García Aparicio Telephone No. +34 91 349 30 57 |

Form PCT/ISA/210 (second sheet) (April 2007)

## INTERNATIONAL SEARCH REPORT

| International application No. |
| --- |
| PCT/ES 2007/070187 |

| C (continuation). | DOCUMENTS CONSIDERED TO BE   RELEVANT | |
| --- | --- | --- |
| Category* | Citation of documents, with indication, where appropriate, of the relevant passages | Relevant to claim No. |
| X | US2004222871 (KAWAI) 11.11.2004<br>Paragraphs [0013]-[0017] | 1-7 |
| Y | WO2005124992 A1 (MITSUBISHI EL. CORP) 29.12.2005<br>Paragraphs [008]-[011] | 8-11 |

Form PCT/ISA/210 (continuation of second sheet) (April 2007)

## INTERNATIONAL SEARCH REPORT

Information on patent family members

International application No.

PCT/ ES 2007/070187

| Patent document cited in the search report | Publication date | Patent family member(s) | Publication date |
|---|---|---|---|
| US 5548279 A | 20.08.1996 | NONE | ------------ |
| US 4185250 A | 22.01.1980 | NONE | ------------ |
| US 4485356 A | 27.11.1984 | NONE | ------------ |
| FR 2582170 A B | 21.11.1986 | NONE | ------------ |
| US 5499392 A | 12.03.1996 | WO 9602975 A<br>AU 3131995 A | 01.02.1996<br>16.02.1996 |
| US 2004222871 A | 11.11.2004 | US 7005950 B<br>JP 2004336511 A | 28.02.2006<br>25.11.2004 |
| WO 2005124992 A | 29.12.2005 | WO 2005125004 A<br>EP 1760876 A<br>EP 20050720170<br>CN 1965471 A<br>US 2007247244 A | 29.12.2005<br>07.03.2007<br>07.03.2005<br>16.05.2007<br>25.10.2007 |

Form PCT/ISA/210 (patent family annex) (April 2007)

INTERNATIONAL SEARCH REPORT

International application No.

PCT/ ES 2007/070187

CLASSIFICATION OF SUBJECT MATTER

*H03H 11/44* (2006.01)
*H03H 11/10* (2006.01)
*H03B 5/08* (2006.01)

Form PCT/ISA/210 (extra sheeet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 9602975A1 A1

### Non-patent literature cited in the description

- **A. Antoniou.** Realization of gyrators using operational amplifiers and their use in RC-active network synthesis. *Proc. IEE,* vol. 116, 1838-1850
- **T. Deliyannis ; Y. Sun ; J.K. Fidler.** Continuous-time active filter design. CRC Press, 1999
- **S. Franco.** Design with operational amplifiers and analog integrated circuits. McGraw-Hill, 2001
- **R. Schaumann ; M. E. van Valkenburg,.** Design of analog filters. Oxford University Press, 2001
- **D. M. G. Preethichandra ; K. Shida.** A simple interface circuit to measure very small capacitance changes in capacitive sensors. *Proc. of the 17th IEEE Instrumentation and Measurement Technology Conference,* 2000, vol. 1, 406-4091
- **D. Ramirez-Muñoz ; S. Casans-Berga ; C. Reig.** Current loop generated from a generalized impedance converter: a new sensor signal conditioning circuit. *Review of Scientific Instruments,* 2005, vol. 76 (1), 066103
- **D. Ramírez-Muñoz ; S. Casans-Berga ; C. Reig ; P. J. P. Freitas.** Generalized impedance converter as a new sensor signal conditioning circuit. *Proc of the 22nd IEEE Instrumentation and Measurement Technology Conference,* 17 May 2005, 587-591
- **D. Ramirez ; S. Casans ; C. Reig ; A. E. Navarro ; J. Sánchez.** Build a precise DC floating-current source. *EDN,* August 2005, 83-84
- **M. Villalobos Pedrero ; D. Ramirez Muñoz ; S. Casans Berga ; J. Sánchez Moreno ; C. Reig Escrivá ; A. E. Navarro Antón.** Red de sensores inteligentes configurable basada en micropocesador con enlace RF accesible via Internet. *Mundo Electrónico*
- **A. Blat González ; D. Ramirez Muñoz ; J. Sánchez Moreno ; S. Casans Berga ; A. E. Navarro Antón ; F. Maturell Nápoles.** Sistema de medida de temperatura y presión con sensores alimentados a corriente constante mediante convertidor generalizado de impedancias. *Mundo Electrónico,* (372
- **D. Ramirez Muñoz ; J. Sánchez ; S. Casans ; C. Reig ; A. E. Navarro.** Series Sensor Current Loop from a Generalized Impedance Converter Circuit with Reference Current Input. *Proc of the 23rd IEEE Instrumentation and Measurement Technology Conference,* 24 April 2006, 2265-2270
- **D. Ramirez Muñoz ; J. Sánchez ; S. Casans ; C. Reig ; A. E. Navarro.** Current-to-current converter from a DC polarized generalized impedance converter circuit with input reference current. *Review of Scientific Instruments,* May 2006, vol. 77, 056101
- **D. Ramirez Muñoz ; J. Sánchez Moreno ; S. Casans Berga ; E. Castro Montero ; C. Reig ; A. E. Navarro Antón.** Temperature compensation of Wheatstone bridge magnetoresistive sensors based on generalized impedance converter with input reference current. *Review of Scientific Instruments,* October 2006, vol. 17 (10), 105102